# EUROPÄISCHE PATENTANMELDUNG

(11) **EP 3 796 021 A1**
(43) Veröffentlichungstag der Anmeldung: **24.03.2021**
(21) Anmeldenummer: 19197975.6
(22) Anmeldetag: 18.09.2019
(51) Int. Cl.: G01R 33/36

(54) **UNTERDRÜCKUNG VON HOCHFREQUENZ-STÖRSIGNALEN BEI MAGNETRESONANZANLAGEN**

(71) Anmelder: Siemens Healthcare GmbH, 91052 Erlangen (DE)
(72) Erfinder: Biber, Stephan, 91056 Erlangen (DE); Vester, Markus, 90471 Nürnberg (DE)

(57) **Zusammenfassung**

Die Erfindung betrifft eine Magnetresonanzanlage (1) mit einer Magneteinheit (2) zur Erzeugung eines B0-Polarisationsfeldes. Die Magneteinheit (2) umgibt mindestens eine elektrische Komponente (22-26) und ist ausgestaltet, ein Untersuchungsobjekt (4) zumindest teilweise zu umgeben. Die Magnetresonanzanlage (1) umfasst ferner eine Steuereinrichtung (6) zur Ansteuerung der mindestens einen elektrischen Komponente (22-26), mindestens eine Zuleitung (9), welche die Steuereinrichtung (6) mit der mindestens einen elektrischen Komponente (22-26) koppelt, und mindestens eine Mantelwellensperrvorrichtung (41-62), welche an der mindestens einen Zuleitung (9) außerhalb der Magneteinheit (2) angebracht ist.

## Beschreibung

Die vorliegende Erfindung betrifft eine Magnetresonanzanlage, bei welcher Hochfrequenz-Störsignale verringert und/oder unterdrückt werden.

Magnetresonanzanlagen werden beispielsweise in der medizinischen Diagnostik zur Durchführung von Magnetresonanztomografien verwendet. Die Magnetresonanztomografie ist ein bildgebendes Verfahren, welches zur Darstellung von Struktur und Funktion der Gewebe und Organe im Körper eingesetzt werden kann. Die Magnetresonanztomografie basiert physikalisch auf den Prinzipien der Kernspinresonanz. Mit einer Magneteinheit, welche ein starkes äußeres Magnetfeld erzeugt, werden Spins von Atomkernen im Untersuchungsobjekt mit dem starken äußeren Magnetfeld ausgerichtet und durch ein magnetisches Wechselfeld (Hochfrequenzimpulse) zur Präzession um diese Ausrichtung resonant angeregt. Zur Erzeugung des magnetischen Wechselfeldes können beispielsweise eine Ganzkörper-Sende-/Empfangsspule in der Magneteinheit oder sogenannte Lokalspulen an dem Untersuchungsobjekt vorgesehen sein. Die Präzession bzw. Rückkehr der Spins der angeregten Atomkerne in einen Zustand mit geringerer Energie erzeugt ein magnetisches Wechselfeld, welches in einem Empfänger ein elektrisches Signal induziert. Mithilfe von magnetischen Gradientenfeldern kann den Signalen eine Ortscodierung aufgeprägt werden, welche eine Zuordnung von dem empfangenen Signal zu einem Volumenelement des Untersuchungsobjektes ermöglicht. Die Gradientenfelder können von einem Gradientenfeldsystem in der Magneteinheit erzeugt werden. Die empfangenen Signale können dann ausgewertet werden, um eine dreidimensionale Darstellung des Untersuchungsobjektes zu erzeugen.

Zur Anregung der Spins der Atomkerne werden Hochfrequenzimpulse mit hoher Leistung erzeugt, welche nur teilweise im Untersuchungsobjekt absorbiert werden. Ein Teil dieser Hochfrequenzimpulse kann daher die Magnetresonanzanlage verlassen und Hochfrequenzstörsignale in der Umgebung der Magnetresonanzanlage erzeugen. Die für die Bildgebung empfangenen Signale sind extrem klein und können daher leicht durch Störsignale von außen beeinträchtigt werden.

Bei üblichen heutigen Magnetresonanzanlagen ist die größte zu installierende Komponente nicht die Magneteinheit, sondern eine Hochfrequenz-Schirmkabine, welche die Magneteinheit, die Patientenliege und die sich in dem Raum bewegenden Personen umfasst. Die Hochfrequenz-Schirmkabine schirmt den Raum in allen Richtungen mit beispielsweise 100 dB Schirmdämpfung ab. Fenster und Türen können mit speziellen Hochfrequenz-Dichtungssystemen und Metallgittern ausgestattet sein, um die hohe Schirmdämpfung zu realisieren. Die Aufgabe der Schirmkabine umfasst eine Verringerung von Emissionen und Immissionen elektromagnetischer Wellen. Das Magnetresonanzsystem strahlt elektromagnetische Wellen in die Umgebung ab, welche die üblichen Grenzwerte (EMV) in einigen Frequenzbereichen überschreiten können. Beispielsweise muss eine Aussendung der Hochfrequenzimpulse der Ganzkörper-Sende-/Empfangsspule (Body Coil) in die Umgebung verringert oder unterbunden werden, um eine Störung der Umgebung im Sendebetrieb zu verhindern. Andererseits kann das Magnetresonanzsystem von externen Störern beeinflusst werden, da die rauscharmen Empfänger, welche beispielsweise eine Rauschzahl von 0,5 dB aufweisen, sehr empfindlich sind und die Magnetresonanzsignale aus dem Körper des Menschen somit leicht von externen Störern überlagert werden können. Dadurch können Störungen im Bild in Form von Artefakten oder erhöhtem Rauschen entstehen. Aus Kosten- und Raumnutzungsgründen ist eine Verringerung der Anforderungen an eine Schirmdämpfung der Hochfrequenz-Schirmkabine wünschenswert.

Bei einer Verringerung der Schirmdämpfung der Hochfrequenz-Schirmkabine können Störungen durch Immissionen verringert werden, indem Funkstörsignale erfasst und durch nachträgliche Berechnungsverfahren von den empfangenen Nutzsignalen subtrahiert werden. Verfahren und Vorrichtungen mit einer derartigen aktiven Störunterdrückung sind beispielsweise aus der WO 2019/068687, der US 8,816,684 B2, der US 2008/0048658 A1, der US 2008/0315879 A1 und der WO 2013/016639 A1 bekannt. Beispielsweise kann eine erste Empfangsantenne zum Empfang eines Magnetresonanzsignals aus einem Patienten in einem Patiententunnel vorgesehen sein und darüber hinaus kann eine zweite Empfangsantenne zum Empfang eines Signals mit der Lamorfrequenz des Magnetresonanzsignals außerhalb und in der Nähe der Öffnung des Patiententunnels angeordnet sein. Ein Empfänger steht in Verbindung mit der ersten Empfangsantenne und der zweiten Empfangsantenne und ist ausgelegt, ein mit der zweiten Empfangsantenne empfangenes Störsignal in einem von der ersten Empfangsantenne empfangenen Magnetresonanzsignal zu unterdrücken.

Bei einer Verringerung der Schirmdämpfung der Hochfrequenz-Schirmkabine können weitere Störungen durch Immissionen auftreten, welche die Bilderzeugung beeinträchtigen können. Aufgabe der vorliegenden Erfindung ist es daher, Auswirkungen derartiger Störungen zu verringern oder zu verhindern.

Diese Aufgabe wird gemäß der vorliegenden Erfindung durch eine Magnetresonanzanlage nach Anspruch 1 gelöst. Die abhängigen Ansprüche definieren Ausführungsformen der Erfindung.

Gemäß der vorliegenden Erfindung wird eine Magnetresonanzanlage mit einer Magneteinheit und einer Steuereinrichtung bereitgestellt. Die Magneteinheit dient zur Erzeugung eines B0-Polarisationsfeldes. Die Magneteinheit umgibt mindestens eine elektrische Komponente und ist ausgestaltet, ein Untersuchungsobjekt zumindest teilweise zu umgeben. Die Magneteinheit kann beispielsweise röhrenförmig ausgebildet sein und ein Untersuchungsobjekt, beispielsweise ein Patient, kann zumindest teilweise innerhalb einer Öffnung der röhrenförmigen Magneteinheit angeordnet werden. Die Steuereinrichtung dient zur Ansteuerung der mindestens einen elektrischen Komponente.

Die Magnetresonanzanlage umfasst weiterhin mindestens eine Zuleitung, welche die Steuereinrichtung mit der mindestens einen elektrischen Komponente koppelt. Ferner umfasst die Magnetresonanzanlage mindestens eine Mantelwellensperrvorrichtung, welche an der mindestens einen Zuleitung außerhalb der Magneteinheit angebracht ist.

Bei Magnetresonanzanlagen verlaufen eine Vielzahl verschiedener Kabel und Leitungen zwischen der Magneteinheit und der Steuereinrichtung. Diese Kabel und Leitungen können als Antennen fungieren und Signale aus der Umgebung aufnehmen. Diese können dann in der Magneteinheit abgestrahlt werden und an Empfangsspulen, beispielsweise der Ganzkörper-Sende-/Empfangsspule oder Lokalspulen ankoppeln und die von diesen Empfangsspulen aufgenommenen Messsignale beeinträchtigen. Derartige leitungsgebundene Störungen können von Empfangsantennen einer aktiven Störunterdrückung gemäß dem Stand der Technik nicht oder nur unzureichend erfasst und somit nicht oder nur unzureichend kompensiert werden. Durch die Verwendung von Mantelwellensperren auf diesen Zuleitungen können die von den Zuleitungen aufgenommenen Störungen verringert oder unterdrückt werden. Vorzugsweise werden an allen Zuleitungen zwischen der Magneteinheit und der Steuereinrichtung entsprechende Mantelwellensperrvorrichtungen außerhalb der Magneteinheit angebracht. Indem die Mantelwellensperrvorrichtungen außerhalb der Magneteinheit angebracht werden, kann sichergestellt werden, dass die Mantelwellensperrvorrichtungen selbst einen Messbereich innerhalb der Magneteinheit nicht beeinflussen und somit die Erfassung von Magnetresonanzaufnahmen nicht stören.

Die mindestens eine Komponente, welche innerhalb der Magneteinheit angeordnet ist, kann beispielsweise eine Ganzkörper-Sende-/Empfangsspule, eine sogenannte Body Coil, umfassen. Die Ganzkörper-Sende-/Empfangsspule ist im Prinzip eine Hochfrequenzantenne, mit welcher Hochfrequenzimpulse in ein Messobjekt, beispielsweise einen Patienten, innerhalb der Magneteinheit eingekoppelt und mit welcher Hochfrequenzmesssignale von dem Messobjekt empfangen werden können. Die Steuereinrichtung steuert die Ganzkörper-Sende-/Empfangsspule zur Erzeugung der Hochfrequenzimpulse an und verarbeitet die Messsignale von der Ganzkörper-Sende-/Empfangsspule zur Erstellung von Magnetresonanzaufnahmen.

Die mindestens eine Komponente, welche innerhalb der Magneteinheit angeordnet ist, kann ferner alternativ oder zusätzlich eine Gradientenspule eines Gradientenfeldsystems der Magnetresonanzanlage umfassen. Das Gradientenfeldsystem kann mehrere Gradientenspulen umfassen, beispielsweise eine oder mehrere Gradientenspulen für jede Raumrichtung, um eine Ortscodierung des empfangenen Messsignals zu ermöglichen. Auch das Gradientenfeldsystem wird üblicherweise von der Steuereinrichtung zur Erzeugung der Ortscodierung angesteuert.

Die mindestens eine Komponente kann weiterhin alternativ oder zusätzlich eine Beleuchtungsvorrichtung zur Beleuchtung eines Patiententunnels in der Magneteinheit, eine Kamera beispielsweise zur Beobachtung des Patienten in dem Patiententunnel, und/oder eine Anzeigevorrichtung am oder in dem Patiententunnel umfassen. Da Zuleitungen zu diesen Komponenten prinzipiell wie Antennen wirken können und somit Störungen außerhalb der Magneteinheit aufnehmen können und in die Magneteinheit einkoppeln können, kann die Anbringung von entsprechenden Mantelwellensperrvorrichtungen an den Zuleitungen zu diesen Komponenten dazu beitragen, dass entsprechende Störungen keinen Einfluss auf die Erfassung von Messsignalen innerhalb der Magneteinheit haben.

Als Mantelwellensperrvorrichtung kann beispielsweise ein Ferrit-Ring, ein LC-Glied und/oder eine Sperrtopfschaltung verwendet werden.

Der Ferrit-Ring stellt eine technisch verhältnismäßig einfache Lösung dar. Beispielsweise kann die Zuleitung durch den Ferrit-Ring oder in mehreren Windungen durch den Ferrit-Ring geführt werden. Durch die hohen Magnetfeldstärken in der Nähe der Magneteinheit kann sich der Ferrit-Ring in der magnetischen Sättigung befinden. Daher kann der Ferrit-Ring nur in einer größeren Entfernung von der Magneteinheit angeordnet werden, beispielsweise in einem Abstand von mindestens 1 m oder beispielsweise in einem Abstand von mindestens 2 m. Der Ferrit-Ring kann beispielsweise auch in einem Abstand angeordnet werden, in welchem die magnetische Feldstärke einen vorgegebenen Schwellenwert unterschreitet, beispielsweise 0,01 mT oder 0,1 mT.

Ein LC-Glied oder eine Sperrtopfschaltung können auch näher an der Magneteinheit verwendet werden, da die Funktionsfähigkeit dieser Mantelwellensperrvorrichtungen nicht durch magnetische Felder beeinträchtigt wird. LC-Glied und Sperrtopfschaltung können beispielsweise in einem Abstand von weniger als 2 m von der Magneteinheit, insbesondere in einem Abstand von weniger als 1 m von der Magneteinheit, an entsprechenden Zuleitungen angebracht werden. Die Sperrtopfschaltung kann insbesondere in Verbindung mit Koaxialleitungen verwendet werden, da die Sperrtopfschaltung im Wesentlichen Ströme auf dem Außenleiter einer Koaxialleitung verhindert, ohne das Signal auf dem Innenleiter wesentlich zu beeinflussen. Sperrtopfschaltungen sind auch unter dem Begriff λ/4-Topfkreis oder Bazooka bekannt. Eine Sperrtopfschaltung besteht aus einem inneren Zylinder und einem äußeren Zylinder, welche über die Leitung, beispielsweise eine Koaxialleitung, gestülpt werden. Der innere Zylinder und der äußere Zylinder bilden eine Kapazität oder sind über eine Kapazität miteinander gekoppelt. Zusammen bilden der innere und der äußere Zylinder eine Induktivität für die Leitung, insbesondere für den Außenleiter einer Koaxialleitung.

Bei einer Ausführungsform umfasst die Mantelwellensperrvorrichtung einen Resonanzsperrkreis mit einer maximalen Impedanz bei einer Resonanzfrequenz der Magnetresonanzanlage. Eine Ausgestaltung der Mantelwellensperrvorrichtung als LC-Glied ist beispielsweise durch geeignete Auswahl von einer Spule und einem Kondensator möglich. Bei Verwendung einer Sperrtopfschaltung als Mantelwellensperrvorrichtung kann ein Resonanzsperrkreis mit einer maximalen Impedanz bei der Resonanzfrequenz der Magnetresonanzanlage durch eine geeignete Dimensionierung des inneren und äußeren Zylinders und ggf. einer Kapazität, welche den inneren und den äußeren Zylinder koppelt, gebildet werden.

Die Resonanzfrequenz der Magnetresonanzanlage kann eine Frequenz im Bereich von 6 MHz bis 300 MHz sein. Die Resonanzfrequenz kann abhängig von der magnetischen Feldstärke des B0-Polarisationsfeldes sein. Die Resonanzfrequenz der Magnetresonanzanlage kann beispielsweise 8,2 MHz bei einer Magnetresonanzanlage mit einem B0-Polarationsfeld der Stärke von 0,2 T betragen. Die Resonanzfrequenz der Magnetresonanzanlage kann weiterhin beispielsweise 21 MHz (bei beispielsweise 0,5 T), 63,6 MHz (bei beispielsweise 1,5 T), 123,2 MHz oder 127,8 MHz (bei beispielsweise 3 Tesla), oder 295 MHz (bei beispielsweise 7 T) betragen.

Eine Bandbreite des Resonanzsperrkreises kann beispielsweise im Bereich von wenigen Prozent der Resonanzfrequenz liegen, beispielsweise kann die Bandbreite des Resonanzsperrkreises 0,1 % bis 6 % der Resonanzsequenz betragen. Die Bandbreite des Resonanzsperrkreises kann weiterhin im Bereich von 1 % bis 3 % der Resonanzfrequenz liegen. Beispielsweise kann die Bandbreite des Resonanzsperrkreises 500 kHz betragen.

Durch die zuvor beschriebenen Mantelwellensperrvorrichtungen und die Eigenschaften der zuvor beschriebenen Mantelwellensperrvorrichtungen können Störungen, welche auf die Zuleitungen eingekoppelt werden, um 20 bis 80 dB gedämpft werden. Dadurch können Immissionen verringert und somit Störungen bei der Bilderfassung vermieden werden. Darüber hinaus können auch Emissionen von den Zuleitungen, welche in der Magneteinheit auf die Zuleitungen eingekoppelt werden, in gleichem Maße gedämpft werden, so dass entsprechende Schirmungen außerhalb der Magneteinheit einfacher ausgestaltet werden können.

Die vorliegende Erfindung wird nachfolgend unter Bezugnahme auf die Zeichnungen anhand bevorzugter Ausführungsformen erläutert werden.
Fig. 1 zeigt schematisch eine Magnetresonanzanlage gemäß einer Ausführungsform der vorliegenden Erfindung.
Fig. 2 zeigt schematisch eine Schnittansicht der Magnetresonanzanlage der Fig. 1.
Fig. 3 zeigt schematisch ein LC-Glied, welches als Mantelwellensperrvorrichtung gemäß der vorliegenden Erfindung eingesetzt werden kann.
Fig. 4 zeigt schematisch einen Ferrit-Ring, welcher als Mantelwellensperrvorrichtung gemäß der vorliegenden Erfindung eingesetzt werden kann.

Nachfolgend werden exemplarische Ausführungsformen der vorliegenden Erfindung im Detail beschrieben werden. Es ist klar, dass die Merkmale der verschiedenen hierin beschriebenen exemplarischen Ausführungsformen miteinander kombiniert werden können. Gleiche Bezugszeichen in den verschiedenen Figuren bezeichnen gleiche oder ähnliche Komponenten.

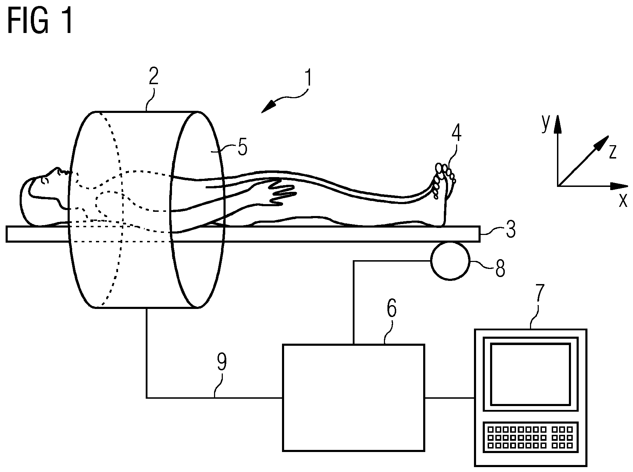

Fig. 1 zeigt eine Magnetresonanzanlage 1. Die Magnetresonanzanlage 1 umfasst eine Magneteinheit 2, den sogenannten Tomografen, sowie einen Untersuchungstisch 3 für einen Patienten 4, welcher sich in einer Öffnung 5 der Magneteinheit 2 befindet. Die Magnetresonanzanlage umfasst ferner eine Steuereinrichtung 6, eine Auswertevorrichtung 7 und eine Antriebseinheit für den Untersuchungstischs 3. Die Steuereinrichtung 6 ist über eine oder mehrere Zuleitungen 9 mit Komponenten in der Magneteinheit 2 elektrisch verbunden. Die Steuereinrichtung 6 steuert die Komponenten in der Magneteinheit 2 an und empfängt Signale von den Komponenten der Magneteinheit 2, welche in der Magneteinheit 2 aufgenommen werden. Weiterhin steuert die Steuereinrichtung 6 die Antriebseinheit 8 an, um den Untersuchungstischs 3 entlang einer Richtung X zusammen mit dem Patienten 4 durch die Öffnung 5 der Magneteinheit 2 zu bewegen. Die Auswertevorrichtung 7 wertet die von der Magneteinheit 2 aufgenommenen Signale zur Erzeugung eines Magnetresonanzbildes bzw. einer Magnetresonanzaufnahme aus. Die Auswertevorrichtung 7 ist beispielsweise ein Computersystem mit einem Bildschirm, einer Tastatur und einem Zeigereingabegerät, z. B. einer elektronischen Maus, um einem Benutzer der Magnetresonanzanlage 1 eine Benutzeroberfläche bereitzustellen.

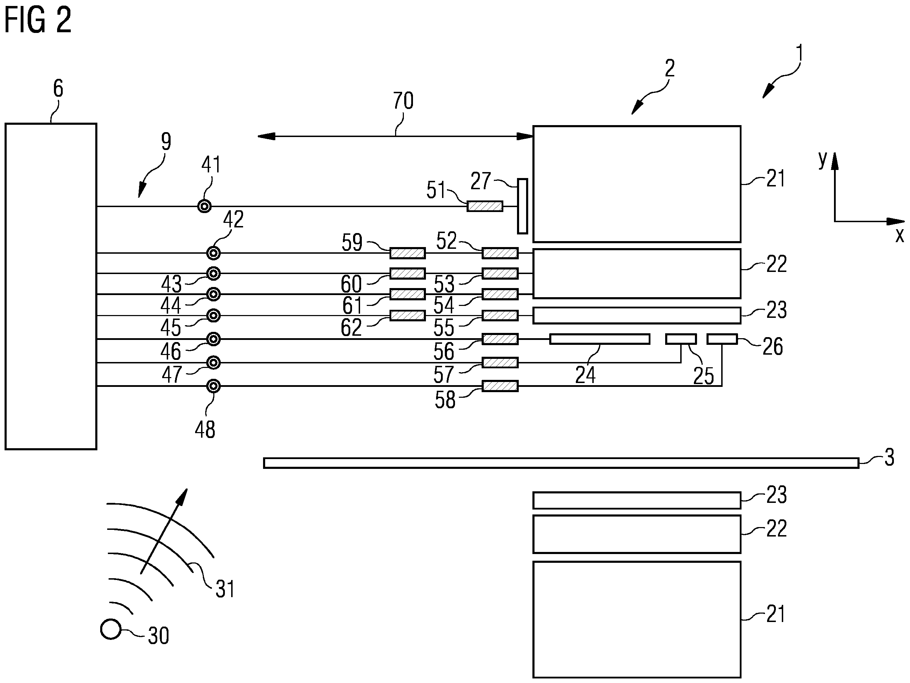

Fig. 2 zeigt eine Querschnittsansicht der Magnetresonanzanlage 1 der Fig. 1 in einer X-Y-Ebene. Die Magneteinheit 2 umfasst einen Grundfeldmagneten 21 zur Erzeugung eines Polarisationsfeldes B0, welches auch als Grundmagnetfeld bezeichnet wird. Das Polarisationsfeld B0 kann eine beträchtliche Magnetfeldstärke im Bereich von einigen 100 mT bis hin zu mehreren T aufweisen. Typische Magnetresonanzanlagen haben ein Polarisationsfeld B0 mit einer Magnetfeldstärke von beispielsweise 1,5 T, 3 T oder sogar 7 T. Der Grundfeldmagnet 21 hat eine ringförmige Struktur. Diese ringförmige Struktur umgibt Komponenten der Magnetresonanzanlage 1, wie z.B. ein Gradientenfeldsystem 22, eine Ganzkörper-Sende-/Empfangsspule 23, eine Lichtleiste 24, eine Kamera 25 und eine Anzeigevorrichtung 26. Eine weitere Anzeigevorrichtung 27 kann beispielsweise an einer Stirnseite der ringförmigen Struktur des Grundfeldmagneten 21 angebracht sein. Die Lichtleiste 24 beleuchtet den von der ringförmigen Struktur des Grundfeldmagneten 21 gebildeten Tunnel, in welchem sich der Untersuchungstisch und ein darauf angeordneter Patient befinden. Mit der Kamera 25 kann ein auf dem Untersuchungstisch 3 angeordneter Patient überwacht und über die Anzeigevorrichtung 26 können dem Patienten Informationen während der Untersuchung angezeigt werden. Mittels der Anzeigevorrichtung 27 können weitere Informationen für Personen im Umfeld der Magneteinheit 2 angezeigt werden.

Das Gradientenfeldsystem 22 kann mehrere Gradientenspulen umfassen, beispielsweise drei Gradientenspulen zur Erzeugung von Gradientenmagnetfeldern in den drei Raumrichtungen X, Y und Z. Mittels der Ganzkörper-Sende-/Empfangsspule 23, welche auch als Hochfrequenzantenne bezeichnet wird, können Hochfrequenzimpulse mit großer Energie im Bereich von einigen kW erzeugt werden, welche Kernspins von Atomen in dem Patienten in einen angeregten Zustand versetzen können. Ferner können mit der Ganzkörper-Sende-/Empfangsspule 23 Messsignale empfangen werden, welche durch die Präzession bzw. Rückkehr der Kernspins aus diesem angeregten Zustand in einen Zustand mit geringerer Energie erzeugt werden. Diese Messsignale können von der Steuereinrichtung 6 und der Auswertevorrichtung 7 zur Erzeugung von Magnetresonanzaufnahmen verwendet werden.

Die Komponenten 22 bis 27 sind über entsprechende elektrische Zuleitungen 9 mit der Steuereinrichtung 6 gekoppelt. Jede der gezeigten elektrischen Zuleitungen 9 kann eine oder mehrere einzeln isolierte Leitungen, mehrere verdrillte Leitungen und/oder eine oder mehrere geschirmte Leitungen, beispielsweise Koaxialleitungen, umfassen.

Eine Störquelle 30 in der Umgebung der Magnetresonanzanlage 1 kann ein Störfeld 31 aussenden, welches Störungen auf die Zuleitungen 9 einkoppelt. Das Störfeld 31 kann beispielsweise elektromagnetische Wellen im Bereich von 1 bis 1000 MHz umfassen. Die auf die Zuleitungen 9 eingekoppelten Störungen können sich auf den Zuleitungen 9 ausbreiten und sowohl die über die Zuleitungen 9 übertragenen Steuersignale beeinflussen als auch die über die Zuleitungen 9 übertragenen Messsignale verfälschen. Darüber hinaus können die Zuleitungen 9 selbst elektromagnetische Störfelder erzeugen, welche in die Umgebung der Magnetresonanzanlage 1 abgestrahlt werden und Störungen auf anderen Zuleitungen 9 der Magnetresonanzanlage 1 einkoppeln können.

Um diese leitungsgebundenen Störfelder zu verringern oder zu unterdrücken, sind an den Zuleitungen 9 Mantelwellensperrvorrichtungen 41 bis 62 vorgesehen. An jeder der Zuleitungen 9 können eine oder mehrere Mantelwellensperrvorrichtungen vorgesehen sein. Fig. 2 zeigt beispielsweise zwei Mantelwellensperrvorrichtungen 41 und 51, welche an der Zuleitung 9 zu der Anzeigevorrichtung 27 vorgesehen sind. An den Zuleitungen 9 zu dem Gradientenfeldsystem 22 sind jeweils drei Mantelwellensperrvorrichtungen vorgesehen, die Mantelwellensperrvorrichtungen 42, 59 und 52 an einer ersten Zuleitung, die Mantelwellensperrvorrichtungen 43, 60 und 53 an einer zweiten Zuleitung und die Mantelwellensperrvorrichtungen 44, 61 und 54 an einer dritten Zuleitung. Auch an der Zuleitung zu der Ganzkörper-Sende-/Empfangsspule 23 sind drei Mantelwellensperrvorrichtungen 45, 62 und 55 vorgesehen. An einer Zuleitung können auch mehr als die gezeigten drei Mantelwellensperrvorrichtungen vorgesehen sein.

An einigen Zuleitungen können auch weniger als die zwei gezeigten Mantelwellensperrvorrichtungen angebracht sein. Beispielsweise kann an einer Zuleitung nur eine Mantelwellensperrvorrichtung angebracht sein, z.B. an der Zuleitung zu der Anzeigevorrichtung 26 nur entweder die Mantelwellensperrvorrichtung 48 oder nur die Mantelwellensperrvorrichtung 58.

Die Mantelwellensperrvorrichtungen 41 bis 62 sind derart ausgebildet, dass sie einen Resonanzsperrkreis mit einer maximalen Impedanz bei der Resonanzfrequenz der Magnetresonanzanlage 1 bilden. Bei einer Magnetresonanzanlage mit einer Grundmagnetfeldstärke von beispielsweise 1,5 T können die Mantelwellensperrvorrichtungen 41 bis 62 jeweils einen Resonanzsperrkreis mit einer maximalen Impedanz bei 63,3 MHz und einer Bandbreite von beispielsweise 500 kHz aufweisen. Bei einer Magnetresonanzanlage mit einer Grundmagnetfeldstärke von beispielsweise 3 T können die Mantelwellensperrvorrichtungen 41 bis 62 jeweils einen Resonanzsperrkreis mit einer maximalen Impedanz bei beispielsweise 123,2 MHz und einer Bandbreite von 1 MHz aufweisen.

Die Mantelwellensperrvorrichtungen 41 bis 62 mit den zuvor genannten Eigenschaften können leitungsgebundene Störfelder auf den Zuleitungen 9 um beispielsweise 20 dB bis 80 dB dämpfen. Dadurch können elektromagnetische Emissionen, insbesondere von beispielsweise einer Ansteuerung der Ganzkörper-Sende-/Empfangsspule 23 wirkungsvoll verringert werden, so dass eine Abschirmung der Magnetresonanzanlage 1, welche beispielsweise als Hochfrequenzkabine oder faradayscher Käfig ausgebildet sein kann, weniger hohe Abschirmungsanforderungen erfüllen muss oder sogar ganz oder teilweise weggelassen werden kann. Ebenso können elektromagnetische Immissionen von einem Störfeld 31 auf beispielsweise Messsignale von der Ganzkörper-Sende-/Empfangsspule 23 wirkungsvoll verringert werden, beispielsweise um bis zu 80 dB.

Wie in der Fig. 2 gezeigt ist, können unterschiedliche Arten von Mantelwellensperrvorrichtungen verwendet werden. In einem Abstand 70 von bis zu 1 oder 2 m von der Magneteinheit 2 können beispielsweise LC-Glieder oder Sperrtopfschaltungen als Mantelwellensperrvorrichtungen 51 bis 62 verwendet werden, da diese nicht oder nur unwesentlich durch magnetische Streufelder der Magneteinheit 2 in ihrer Funktionsweise beeinträchtigt werden. Um die Funktionsweise der Komponenten, insbesondere des Gradientenfeldsystems 22 und der Ganzkörper-Sende-/Empfangsspule 23, und das Grundmagnetfeld B0 sowie das Gradientenmagnetfeld nicht zu beeinträchtigen oder zu beeinflussen, werden die Mantelwellensperrvorrichtungen 51 bis 62 außerhalb der Magneteinheit 2 angeordnet, beispielsweise in einem Abstand von mindestens 10 cm. In einem Abstand 70 von mehr als 1 oder 2 m können neben LC-Gliedern oder Sperrtopfschaltungen auch Ferrit-Ringe als Mantelwellensperrvorrichtungen 41 bis 48 verwendet werden. Die Anordnung von FerritRingen als Mantelwellensperrvorrichtungen 41 bis 48 innerhalb des Abstands 70 sollte vermieden werden, da die Funktionsweise der Ferrit-Ringe durch magnetische Streufelder der Magneteinheit 2 beeinträchtigt werden kann, beispielsweise wenn die Ferrit-Ringe durch die magnetischen Streufelder in die magnetische Sättigung gebracht werden. Der Abstand 70 richtet sich nach der Stärke des Grundmagnetfeldes B0 der Magnetresonanzanlage 1. Der Abstand 70 kann beispielsweise so gewählt werden, dass magnetische Streufelder der Magneteinheit 2 im Abstand 70 unter einem vorgegebenen Schwellenwert liegen, wobei dieser Schwellenwert einen Wert im Bereich von 0,01 bis 0,1 mT haben kann. Bei Magnetresonanzanlagen 1 mit einer Grundmagnetfeldstärke von beispielsweise nur 0,2 T kann der Abstand 70 auch weniger als 1 m betragen. Bei Magnetresonanzanlagen 1 mit einer Grundmagnetfeldstärke von 7 T oder darüber hinaus kann der Abstand 70 auch mehr als 2 m betragen.

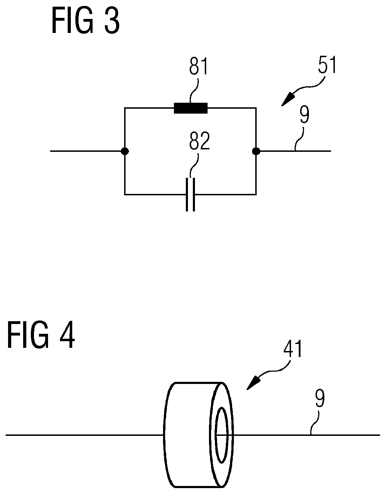

Fig. 3 zeigt eine Ausführungsform einer Mantelwellensperrvorrichtung 51. Die in Fig. 3 gezeigte Ausführungsform kann für eine beliebige der in Fig. 2 gezeigten Mantelwellensperrvorrichtungen 41 bis 62 verwendet werden, insbesondere jedoch für eine der Mantelwellensperrvorrichtungen 51 bis 62. Die Mantelwellensperrvorrichtung 51 umfasst ein LC-Glied, welches eine Parallelschaltung aus einer Induktivität 81 und einer Kapazität 82 umfasst. Das LC-Glied wird in die Leitung 9 eingefügt. Alternativ kann die Induktivität 81 durch schraubenförmiges Wickeln der Zuleitung 9 gebildet werden. Die Größe der Induktivität 81 und der Kapazität 82 werden derart ausgewählt, dass die gewünschte maximale Impedanz bei der Resonanzfrequenz der Magnetresonanzanlage 1 über die gewünschte Bandbreite erreicht wird. Eine entsprechende Dimensionierung der Induktivität 81 und der Kapazität 82 ist dem Fachmann bekannt.

Weiterhin kann als eine der Mantelwellensperrvorrichtungen 41 bis 62 eine Sperrtopfschaltung verwendet werden, welche auch als Bazooka-Mantelwellensperrvorrichtung bezeichnet wird. Die Funktionsweise der Sperrtopfschaltung entspricht im Wesentlichen dem in der Fig. 3 gezeigten LC-Glied. Anstatt einer gewickelten Induktivität und einem Kondensator wird ein Sperrtopf mit beispielsweise zwischen Außen- und Innenfläche eines ggf. auch mehrlagigen Sperrtopfes vorliegender Induktivität und/oder Kapazität vorgesehen.

Fig. 4 zeigt eine Ausführungsform einer Mantelwellensperrvorrichtung 41. Die in Fig. 4 gezeigte Ausführungsform kann für eine beliebige der in Fig. 2 gezeigten Mantelwellensperrvorrichtungen 41 bis 48 verwendet werden. Die Mantelwellensperrvorrichtung 41 umfasst einen Ferrit-Ring, durch welchen die Zuleitung 9 geführt ist. Die Zuleitung 9 kann auch mehrfach durch den Ferrit-Ring geführt werden, indem die Zuleitung 9 mehrfach um den Ferrit-Ring gewickelt wird. Für den Fall, dass die Zuleitung 9 eine Koaxialleitung ist, kann diese ebenfalls durch den Ferrit-Ring geführt werden, um Mantelwellen auf dem Außenleiter der Koaxialleitung zu verringern oder zu unterdrücken.

Zusammenfassend werden aufgekoppelte Störungen durch Mantelwellensperren auf allen Zuleitungen in die Magneteinheit unterdrückt. Dies betrifft insbesondere Zuleitungen zu der Ganzkörper-Sende-/Empfangsspule 23, dem Gradientenfeldsystem 22, der Beleuchtung 24 innerhalb der Magneteinheit 2, den Anzeigevorrichtungen oder Displays 26, 27 an oder in der Magneteinheit 2, der Kamera 25 in der Magneteinheit 2 sowie der Verkabelungen an dem Tisch 3, wie z.B. zu einem Rufball oder Kopfhörer. In der Nähe der Magneteinheit 2 (innerhalb des Abstands 70) können die Mantelwellensperren beispielsweise durch Sperrtöpfe oder gewickelte Mantelwellensperren (LC-Glieder) gebildet werden. Weiter weg (außerhalb des Abstands 70) können auch ferritbasierte Techniken (Ferrit-Ringe) verwendet werden. Durch die Verwendung der Mantelwellensperren können Anforderungen an eine Hochfrequenzkabine, welche die Magnetresonanzanlage 1 umgibt, verringert werden oder es kann ganz auf die Hochfrequenzkabine verzichtet werden.

## Patentansprüche

1. Magnetresonanzanlage (1), umfassend:
- eine Magneteinheit (2) zur Erzeugung eines B0-Polarisationsfeldes, wobei die Magneteinheit (2) mindestens eine elektrische Komponente (22-26) umgibt und ausgestaltet ist, ein Untersuchungsobjekt (4) zumindest teilweise zu umgeben,
- eine Steuereinrichtung (6) zur Ansteuerung der mindestens einen elektrischen Komponente (22-26),
- mindestens eine Zuleitung (9), welche die Steuereinrichtung (6) mit der mindestens einen elektrischen Komponente (22-26) koppelt, und
- mindestens eine Mantelwellensperrvorrichtung (41-62), welche an der mindestens einen Zuleitung (9) außerhalb der Magneteinheit (2) angebracht ist.

2. Magnetresonanzanlage (1) nach Anspruch 1, wobei die mindestens eine elektrische Komponente (22-26) mindestens eine Komponente aus einer Gruppe von Komponenten umfasst, wobei die Gruppe umfasst:
- eine Ganzkörper-Sende-/Empfangsspule (23),
- eine Gradientenspule (22),
- eine Beleuchtungsvorrichtung (24) zur Beleuchtung eines Patiententunnels (5), welchen die Magneteinheit (2) zumindest teilweise umgibt,
- eine Kamera (25), und
- eine Anzeigevorrichtung (26).

3. Magnetresonanzanlage (1) nach Anspruch 1 oder Anspruch 2, wobei die mindestens eine Mantelwellensperrvorrichtung (41-62) mindestens eine Vorrichtung aus einer Gruppe von Vorrichtungen umfasst, wobei die Gruppe umfasst:
- einen Ferritring,
- ein LC-Glied, und
- eine Sperrtopfschaltung.

4. Magnetresonanzanlage (1) nach einem der vorhergehenden Ansprüche, wobei die mindestens eine Mantelwellensperrvorrichtung (41-48) einen Ferritring umfasst, wenn sich die mindestens eine Mantelwellensperrvorrichtung (41-48) in einem Abstand (70) von mindestens 1 m von der Magneteinheit (2) befindet.

5. Magnetresonanzanlage (1) nach einem der vorhergehenden Ansprüche, wobei die mindestens eine Mantelwellensperrvorrichtung (51-62) ein LC-Glied oder eine Sperrtopfschaltung umfasst, wenn sich die mindestens eine Mantelwellensperrvorrichtung (51-62) in einem Abstand (70) von weniger als 2 m von der Magneteinheit (2) befindet.

6. Magnetresonanzanlage (1) nach einem der vorhergehenden Ansprüche, wobei die mindestens eine Mantelwellensperrvorrichtung (41-62) einen Resonanzsperrkreis mit einer maximalen Impedanz bei einer Resonanzfrequenz der Magnetresonanzanlage (1) umfasst.

7. Magnetresonanzanlage (1) nach Anspruch 6, wobei die Resonanzfrequenz der Magnetresonanzanlage (1) eine Frequenz im Bereich von 6 MHz bis 300 MHz aufweist.

8. Magnetresonanzanlage (1) nach Anspruch 6 oder Anspruch 7, wobei die Resonanzfrequenz der Magnetresonanzanlage (1) 8,2 MHz, 21 MHz, 63,6 MHz, 123,2 MHz, 127,8 MHz oder 295 MHz beträgt.

9. Magnetresonanzanlage (1) nach einem der Ansprüche 6-8, wobei eine Bandbreite des Resonanzsperrkreises einen Wert im Bereich von 0,1% bis 6% der Resonanzfrequenz aufweist, vorzugsweise einen Wert im Bereich von 1% bis 3% der Resonanzfrequenz aufweist.

10. Magnetresonanzanlage (1) nach einem der Ansprüche 5-8, wobei eine Bandbreite des Resonanzsperrkreises 500kHz beträgt.
